# EUROPEAN PATENT APPLICATION

(11) **EP 4 815 296 A1**
(43) Date of publication of application: **30.09.2026**
(21) Application number: 25861123.5
(22) Date of filing: 07.04.2025
(51) Int. Cl.: H02S 40/32, H02M 7/00, H02S 40/42, H05K 7/20

(54) **MICROINVERTER**

(30) Priority: 26.08.2024 KR 20240114618
(71) Applicant: Hanwha Solutions Corporation, Jung-gu Seoul 04541 (KR)
(72) Inventor: KIM, Jung Guen, Seoul 04541 (KR); KIM, Joong Tae, Seoul 04541 (KR); PARK, Tae Sung, Seoul 04541 (KR); YUN, Ju Hwan, Seoul 04541 (KR)
(74) Representative: Mooser, Sebastian Thomas
(86) International application number: PCT/KR2025/004682
(87) International publication number: WO 2026/049193

(57) **Abstract**

The present disclosure relates to a microinverter. The microinverter may include a case having an internal space in which a circuit board is disposed, a potting material stored in the internal space of the case and configured to cover the circuit board, and a heat dissipation structure which is disposed to pass through the case and has one side exposed to the outside of the case and the other side in contact with the potting material.

## Description

### Technical Field

The present disclosure relates to a microinverter.

### Background Art

Inverters are devices that convert a DC current into an AC current and are used in various industrial application fields that use electronic devices such as electric motor drives, uninterruptible power supplies (UPSs), and active power filters as well as fields of renewable energy conversion systems including solar power generators, hybrid vehicles, and the like.

Recently, microinverters (MIs) are being applied in the solar power generation inverter market, mainly in the US market. MIs are distributed systems that convert a DC current into an AC current in a module unit by installing a small inverter on each individual solar cell module.

MIs are usually positioned on a rear surface of a solar power generating DC module, but there is a problem in that heat generated when an inverter operates and heat generated when the DC module operates are transferred to the MI to overheat the MI. In addition, with the trend toward miniaturization of MI devices, as circuit elements are integrated in a small volume, heat generated from circuit elements inside MIs reduces conversion efficiency, and heat damage to internal component shortens a lifespan of devices

### Disclosure

### Technical Problem

The present disclosure is directed to providing a microinverter in which the dissipation performance of a case is improved to prevent overheating, thereby increasing conversion efficiency and improving the durability and usability of a device.

### Technical Solution to Problem

An aspect of the present disclosure provides a microinverter including a case having an internal space in which a circuit board is disposed, a potting material stored in the internal space of the case and configured to cover the circuit board, and a heat dissipation structure which is disposed to pass through the case and has one side exposed to the outside of the case and the other side in contact with the potting material.

### Advantageous Effects of the Disclosure

In a microinverter according to an embodiment of the present disclosure, heat from internal components may be discharged to the outside to improve durability, usability, and performance. In a microinverter, since a heat dissipation structure comes into contact with a potting material stored therein and comes into contact with external air, internal heat may be discharged to the outside.

The effects of the present disclosure are not limited to the effects described above, and effects not mentioned may be clearly understood by a person having ordinary skill in the art to which the present disclosure pertains from this specification and the attached drawings.

### Brief Description of Drawings

FIG. 1 is a schematic view illustrating a microinverter according to an embodiment of the present disclosure.
FIG. 2 is a perspective view of the microinverter of FIG. 1 aligned based on a surface on which a heat dissipation structure is installed.
FIG. 3 is an exploded perspective view of the microinverter shown in FIG. 2.
FIG. 4 is a cross-sectional view of a portion at which a sealing cap of FIG. 2 is installed.
FIG. 5 is a view for describing a process of filling a case of FIG. 2 with a potting material.
FIG. 6 is a view for describing a flow path of air in the case of FIG. 2.
FIG. 7 is a schematic view illustrating the heat dissipation structure of FIG. 2.
FIG. 8 is a cross-sectional view taken along line A-A' of FIG. 2.
FIG. 9 is an enlarged view illustrating part C in FIG. 8.
FIG. 10 is a view illustrating another embodiment of the heat dissipation structure shown in FIG. 9.
FIG. 11 is a cross-sectional view taken along line B-B' of FIG. 2.
FIG. 12 is an enlarged view illustrating part D in FIG. 8.
FIG. 13 is a cross-sectional view of a microinverter, which is installed on an external structure, viewed from the side.

### Best Mode

An aspect of the present disclosure provides a microinverter including a case having an internal space in which a circuit board is disposed, a potting material stored in the internal space of the case and configured to cover the circuit board, and a heat dissipation structure which is disposed to pass through the case and has one side exposed to the outside of the case and the other side in contact with the potting material.

In addition, the heat dissipation structure may include first heat dissipation fins protruding from the one surface by a first height, and second heat dissipation fins protruding from the other surface by a second height.

In addition, in the heat dissipation structure, the first height may be different from the second height.

In addition, in the heat dissipation structure, the number of the first heat dissipation fins may be different from the number of the second heat dissipation fins.

In addition, in the heat dissipation structure, a surface area exposed to the outside may be greater than a surface area in contact with the potting material.

In addition, the case may further include a support bracket mounted on the case to face the heat dissipation structure and configured to support the case to an external structure.

In addition, the support bracket may include a bracket body mounted on an installation surface of the external structure, and a snap which extends from the bracket body, is connected to the case, and is configured to separate the case from the installation surface.

In addition, the heat dissipation structure may be disposed on the case to face the installation surface so that a certain interval may be set between the heat dissipation structure and the installation surface.

In addition, the potting material may transfer heat generated from the circuit board to the heat dissipation structure.

In addition, the potting material may be provided as a flowable material and may flow along a surface of the circuit board to dissipate heat generated from the circuit board to surroundings.

Another aspect of the present disclosure provides a microinverter including a case which includes a first case facing outward and a second case facing an external structure, wherein a circuit board is disposed in an internal space of the first case and the second case, a potting material stored in the internal space and configured to cover the circuit board, and a heat dissipation structure which is disposed to pass through the second case and has one side exposed to the outside of the second case and the other side in contact with the potting material, wherein the second case includes a concave portion that is concavely recessed to allow external air to flow, and the heat dissipation structure is disposed on the concave portion.

In addition, the concave portion may be recessed to a preset depth from an outermost surface of the second case adjacent to an installation surface of the external structure on which the case is installed, and the heat dissipation structure may have a certain interval from the installation surface.

In addition, the second case may have at least one gate groove which is connected to the concave portion and through which external air flows into the concave portion.

In addition, the second case may have a third gate groove which faces the heat dissipation structure and through which the external air flows into the concave portion.

In addition, the case may further include a support bracket mounted on the case to face the heat dissipation structure and configured to support the case to the external structure.

In addition, the heat dissipation structure may include a base plate mounted on the second case, a first heat dissipation fin protruding from one surface of the base plate by a first height, and a second heat dissipation fin protruding from the other surface of the base plate by a second height.

In addition, in the heat dissipation structure, the first height may be different from the second height.

In addition, a thickness of the base plate may be less than the first height and may be greater than the second height.

In addition, the second case may include a first injection port through which the potting material is injected, and a second injection port spaced apart from the first injection port.

In addition, the second case may include a first gate groove adjacent to the first injection port and connected to the concave portion, a second gate groove adjacent to the second injection port and connected to the concave portion, and a third gate groove disposed at a side opposite to the first gate groove or the second gate groove and connected to the concave portion.

### Mode of Disclosure

Since the present disclosure can apply various transformations and have various embodiments, specific embodiments will be illustrated in the drawings and described in detail in the detailed description. Effects and features of the present disclosure, and methods for achieving them will become clear with reference to the embodiments described below in detail together with the drawings. However, the present disclosure is not limited to the embodiments disclosed below and may be implemented in various forms.

Hereinafter embodiments of the present disclosure will be described in detail with reference to the accompanying drawings, wherein like reference numerals refer to the same or corresponding components throughout the drawings, and a redundant description thereof will be omitted.

In the following embodiments, the terms first, second, and the like do not have limited meaning but are used for the purpose of distinguishing one component from another component.

In the following embodiments, the expressions used in the singular such as "a," "an," and "the" are intended to include the plural forms as well, unless the context clearly indicates otherwise.

In the following embodiments, it will be understood that the terms such as "including," "comprising," and "having" specify the presence of stated features or components, but do not preclude the presence or addition of one or more other features or components.

In the following embodiments, when an area, a component, or the like is positioned on or above another part, the present disclosure includes not only a case in which the area, the component, or the like is positioned directly above the other part, but also a case in which other areas, other components, or the like may be positioned therebetween.

In the drawings, components may be exaggerated or reduced in size for convenience of description. For example, the sizes and thicknesses of the respective components shown in the drawings are arbitrarily shown for convenience of description, and thus one or more embodiments are not necessarily limited thereto.

In the following embodiments, it will be understood that when an area, a component, or the like is referred to as being connected to another component, it may be directly connected to the other component or intervening components may also be present.

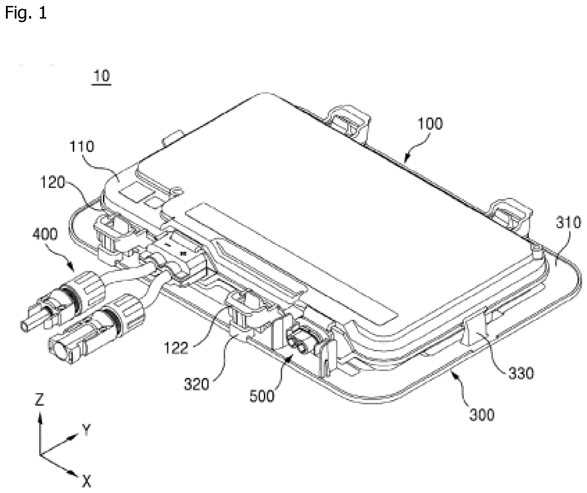

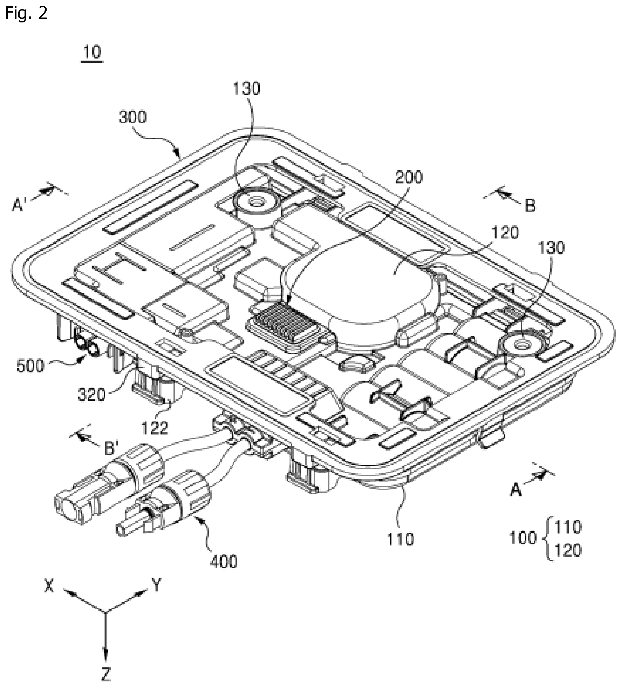

FIG. 1 is a schematic view illustrating a microinverter 10 according to an embodiment of the present disclosure. FIG. 2 is a perspective view of the microinverter 10 of FIG. 1 aligned based on a surface on which a heat dissipation structure 200 is installed.

Hereinafter, with respect to the microinverter 10 shown in FIG. 1, a lateral direction is referred to as an X-axis direction, an anteroposterior direction is referred to as a Y-axis direction, and a vertical direction is referred to as a Z-axis direction.

Referring to FIGS. 1 and 2, the microinverter 10 includes a case 100 storing a circuit board therein, the heat dissipation structure 200, and a support bracket 300 and may be connected to a first connector 400 and a second connector 500.

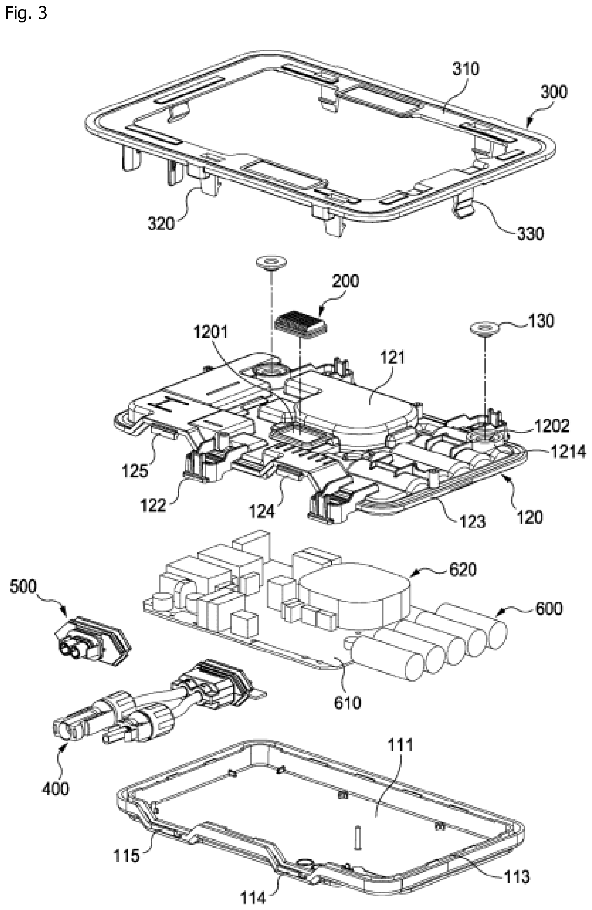

The case 100 may have an internal space. The case 100 may form an exterior of the microinverter 10 and may accommodate a circuit board 600 (see FIG. 3) therein. The case 100 may fix a position of the circuit board 600. For this purpose, the internal shape of the case 100 may correspond to a shape of the circuit board 600.

The case 100 may protect the circuit board 600 disposed therein. For example, in consideration of the stable operation of the microinverter 10 and the influence of the surrounding environment, the case 100 may have functions of heat resistance, moisture resistance, water resistance, electrical insulation, cold resistance, oil resistance, impact resistance, and waterproof.

In an embodiment, the case 100 may include a first case 110 and a second case 120. In the case 100, the first case 110 and the second case 120 may be assembled to face each other in the Z-axis direction.

The first case 110 and the second case 120 may include connection positions for the first connector 400 and the second connector 500. The first connector 400 and the second connector 500 may be interposed between the first case 110 and the second case 120, and the connection position for the first connector 400 and the connection position for the second connector 500 may be set.

According to an embodiment, the first connector 400 and the second connector 500 may be disposed in parallel to each other in the X-axis direction on the same side surface of the case 100. The first connector 400 and the second connector 500 may insulated from each other so that a current may be input and output through each connector.

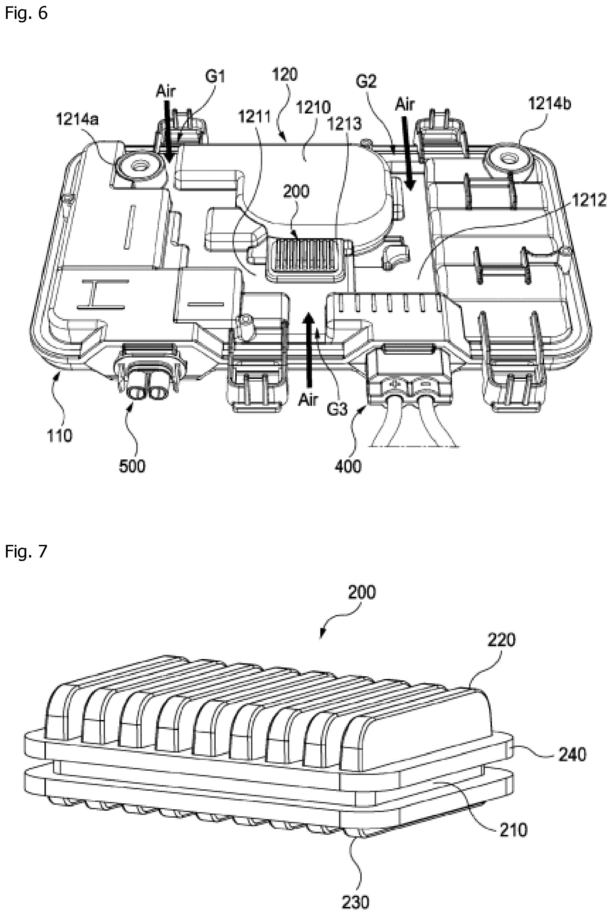

According to an embodiment, the case 100 may store a potting material (see FIG. 6) in the internal space. The internal space of the case 100 may be sealed to prevent the outflow of the potting material accommodated therein or prevent the permeation of external foreign materials.

For example, the case 100 may have an injection port, through which the potting material is injected, at one side thereof, and may include a sealing cap 130 for sealing the injection port. In addition, in the case 100, an assembly portion between the first case 110 and the second case 120, the connection position for the first connector 400, and the connection position for the second connector 500 may be sealed.

The heat dissipation structure 200 may be positioned on one surface of the case 100 and positioned to pass through the case 100. The heat dissipation structure 200 may be made of a material having thermal conductivity to transfer heat generated inside the case 100 to the outside. The heat dissipation structure 200 may dissipate heat generated while the microinverter 10 operates, thereby preventing overheating to improve conversion efficiency and extend a lifespan of components.

The support bracket 300 may be provided to support one surface of the case 100. The support bracket 300 may be positioned to face the case 100 in the Z-axis direction. For example, the support bracket 300 may be disposed adjacent to the second case 120.

In a state of being assembled with the case 100, the support bracket 300 may be installed on an external structure such as another device, a building, or the like. The microinverter 10 may be installed by being fixed at a desired installation position by the support bracket 300.

According to an embodiment, the case 100 and the support bracket 300 may be assembled by a locking unit. The locking unit may include a first locker and a second locker which are provided to be assembled with each other. When one of the case 100 and the support bracket 300 has a first locker, the other thereof may have a second locker assembled with the first locker.

For convenience of description, hereinafter, descriptions will be provided based on an embodiment in which a first locker 122 is provided on the case 100 and a second locker 320 is provided on the support bracket 300.

According to an embodiment, the first locker 122 may be disposed at on one side of the case 100, and the second locker 320 may be disposed on the support bracket 300 at a position corresponding to the first locker 122. The first locker 122 and the second locker 320 may be assembled to fix the case 100 to the support bracket 300. A plurality of first lockers 122 and a plurality of second lockers 320 may be provided.

FIG. 3 is an exploded perspective view of the microinverter 10 shown in FIG. 2.

Referring to FIG. 3, the microinverter 10 may include the first case 110, the second case 120, the heat dissipation structure 200, the circuit board 600, the support bracket 300, the first connector 400, and the second connector 500.

According to an embodiment, the first case 110 may include a cover 111, a joint groove 113, a first fitting piece 114, and a second fitting piece 115.

The cover 111 may be provided in an approximately plate shape that covers one surface of the circuit board 600. The cover 111 may be provided to cover an upper surface of the circuit board 600. The cover 111 may be exposed to the outside when the microinverter 10 is installed on an external structure.

The joint groove 113 may be formed in a surface of the cover 111 facing the second case 120. According to an embodiment, the joint groove 112 may be formed along a perimeter of a lower surface of the cover 111. The joint groove 112 may be provided to be coupled to a base protrusion 123 of the second case 120.

The first fitting piece 114 may be provided at one side of the cover 111 and fastened to the first connector 400 connected to the case 100. The first fitting piece 114 may be positioned adjacent to a position at which the first connector 400 is connected. For example, the first fitting piece 114 may be provided as a protrusion that protrudes from a surface of the first case 110 which is in contact with the first connector 400.

The second fitting piece 115 may be provided at the other side of the cover 111 and fastened to the second connector 500 connected to the case 100. The second fitting piece 115 may be positioned adjacent to a position at which the second connector 500 is connected. For example, the second fitting piece 115 may be provided as a protrusion that protrudes from a surface of the first case 110 which is in contact with the second connector 500.

According to an embodiment, the second case 120 may include a base 121, the first locker 122, the base protrusion 123, a third fitting piece 124, and a fourth fitting piece 125.

The base 121 may be positioned opposite to the cover 111 and may be provided to cover the other surface of the circuit board 600. The base 121 may correspond to a shape of a bottom surface of the circuit board 600. The base 121 may support the circuit board 600 to fix a position of the circuit board 600.

The first locker 122 may be disposed at an edge of the second case 120. The first locker 122 may be provided to be assembled with the second locker 320 of the support bracket.

The base protrusion 123 may be formed on a surface facing the first case 110. According to an embodiment, the base protrusion 123 may be formed along a perimeter of an upper surface of the base 121. The base protrusion 123 may be provided to be coupled to the joint groove 112.

The third fitting piece 124 may be provided at one side of the base 121 and may be fastened to the first connector 400 connected to the case 100. The third fitting piece 124 may be positioned adjacent to a position at which the first connector 400 is connected. For example, the third fitting piece 124 may be provided as a protrusion that protrudes from a surface of the second case 120 which is in contact with the first connector 400.

The fourth fitting piece 125 may be provided at the other side of the base 121 and fastened to the second connector 500 connected to the case 100. The fourth fitting piece 125 may be disposed adjacent to a position at which the second connector 500 is connected. For example, the fourth fitting piece 125 may be provided as a protrusion that protrudes from a surface of the second case 120 which is in contact with the second connector 500.

According to an embodiment, the second case 120 may have a fixing hole 1201 into which the heat dissipation structure 200 is inserted, and an injection hole 1202 for injecting the potting material.

The fixing hole 1201 may be provided as a hole passing through the second case 120 such that the heat dissipation structure 200 is fitted and fixed therein. The fixing hole 1201 may be provided in a shape corresponding to a shape of the heat dissipation structure 200.

As an example, when the second case 120 and the heat dissipation structure 200 are each formed separately, the fixing hole 1201 may be provided in a shape that may be fastened to the heat dissipation structure 200.

As another example, when the second case 120 and the heat dissipation structure 200 are manufactured as an integrated structure using a double injection method, the fixing hole 1201 may be defined as a boundary surface between the second case 120 and the heat dissipation structure 200.

Although the second case 120 is illustrated in the drawing as having one fixing hole 1201, one or more embodiments are not limited thereto, and a different number of fixing holes 1201 may be formed as needed. For example, at least one fixing hole 1201 may be formed in a concave portion of the second case 120.

The injection hole 1202 may be provided as a hole passing through the second case 120 to inject the potting material. The injection hole 1202 may be defined by an injection port 1214 formed at one side of the second case 120. The injection hole 1202 may be sealed by the sealing cap 130 after the potting material is injected. Although the second case 120 is illustrated in the drawing as having two injection ports 1214, one or more embodiments are not limited thereto, and a different number of injection ports 1214 may be provided as needed.

The circuit board 600 may be disposed between the first case 110 and the second case 120. The circuit board 600 may be accommodated in an internal space formed by assembling the first case 110 and the second case 120. The circuit board 600 may be supported by the first case 110 and the second case 120 so that a position thereof may be fixed.

The circuit board 600 may be provided to convert DC power into AC power. The first connector 400 may be connected to one side of the circuit board 600, and the second connector 500 may be connected to the other side of the circuit board 600.

The circuit board 600 may include electronic circuits and circuit components formed at preset positions of one surface or opposite surfaces of a board. For example, the circuit board 600 may be provided as a typical printed circuit board assembly (PCBA). Hereinafter, descriptions will be provided based on a case in which the circuit board 600 is used singly, but as needed, the circuit board 600 may be used by integrating a plurality of layers.

According to an embodiment, the circuit board 600 may include a substrate unit 610 and a circuit unit 620. The substrate unit 610 may have a plate shape and may have a circuit pattern printed on one surface opposite surfaces or have a surface on which circuit components are disposed. The circuit unit 620 may be disposed on one surface or opposite surfaces of the substrate unit 610. The circuit unit 620 may include a circuit for converting DC power into AC power. The circuit unit 620 may include components such as a circuit pattern printed with copper, an integrated circuit (IC), a capacitor, and a transformer which are disposed on the substrate unit 610. For example, the circuit unit 620 may include a voltage boosting circuit for boosting an input DC voltage and a conversion circuit for converting DC power into AC power and may include respective circuit components.

According to an embodiment, the support bracket 300 may include a bracket body 310, the second locker 320, and a snap 330.

The bracket body 310 may support a lower surface of the second case 120 or may be positioned to face and be spaced apart from the lower surface of the second case 120. The bracket body 310 may be mounted on an installation surface when the microinverter 10 is installed on an external structure.

The second locker 320 may be provided on an upper surface of the bracket body 310 and disposed at a position corresponding to the first locker 122. The second locker 320 may be provided to be assembled to the first locker 122.

The snap 330 may be formed to protrude from the bracket body 310 by a certain height. The snap 330 may be assembled to the case 100 through a typical snap-fit fastening method. A snap-fit fastening method is a method of fitting and fastening a hook into a certain groove or one surface and a method of connecting two components without a separate connection member.

According to an embodiment, the snap 330 may have a snap-fit structure that is connected to one side of the first case 110 or the second case 120. At least a portion of the snap 330 may have elasticity, and the second case 120 may be connected to the snap 330 through force fitting. The case 100 may be installed on an external structure by being connected to the snap 330. In this case, according to a protrusion height of the snap 330, the case 100 may be fixed at a position spaced apart from an installation surface.

The first connector 400 and the second connector 500 may be provided to connect the microinverter 10 to the outside. The first connector 400 and the second connector 500 may be connected to an external power source and power system using a cable or other connectors.

According to an embodiment, the first connector 400 may be provided as a DC connector, and the second connector 500 may be provided as an AC connector.

The first connector 400 may be connected directly to the circuit board 600. One side of the first connector 400 may be connected to the circuit board 600. A solar cell module (not shown) may be connected to the other side of the first connector 400. The solar cell module is a device that converts light energy into electrical energy through a photovoltaic effect. The first connector 400 may receive DC power generated from the solar cell module and may transmit the received DC power to the circuit board 600.

The second connector 500 may be connected directly to the circuit board 600. One side of the second connector 500 may be connected to the circuit board 600. A power system (not shown) may be connected to the other side of the second connector 500. The second connector 500 may output AC power converted from the circuit board 600 and may transmit the output AC power to the power system through an AC output cable.

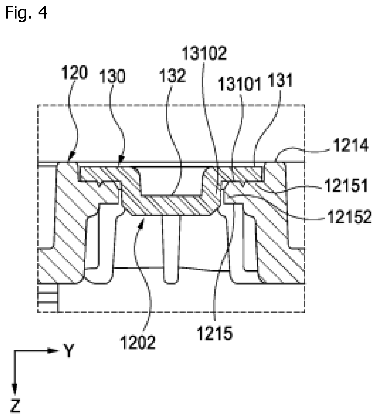

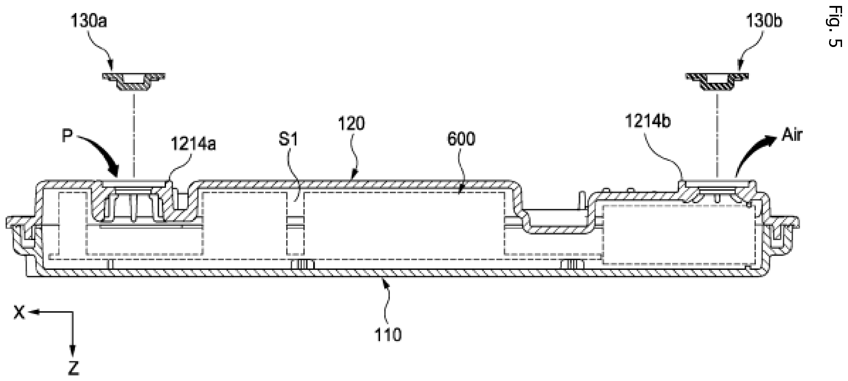

FIG. 4 is a cross-sectional view of a portion at which the sealing cap 130 of FIG. 2 is installed. FIG. 5 is a view for describing a process of filling the case 100 of FIG. 2 with a potting material P.

Referring to FIGS. 2, 4, and 5, the sealing cap 130 may be coupled to the injection hole 1202 of the second case 120 to seal an internal space S1 of the case 100.

The sealing cap 130 may be provided to seal the injection hole 1202. Hereinafter, a surface exposed to the outside of the case 100 is defined as an outer surface, and a surface facing the internal space S1 of the case is defined as an inner surface.

According to an embodiment, the sealing cap 130 may include a joint portion 131 and an insertion portion 132. The joint portion 131 may be an edge portion of the sealing cap 130 and may be joined to a periphery of the injection hole 1202. The insertion portion 132 may be formed by a central portion of the sealing cap 130 being concavely recessed and may be provided to be inserted into the injection hole 1202.

As an optional embodiment, the second case 120 may include the injection port 1214 that protrudes outward. The injection hole 1202 may extend in a tubular shape by the injection port 1214.

The injection port 1214 may be formed in a tubular shape extending in a -Z direction from the injection hole 1202. The injection port 1214 may expand a depth by which the sealing cap 130 is inserted and may support at least a circumferential surface of the sealing cap 130. A supporter 1215 may be further provided on an inner wall of the injection port 1214.

The supporter 1215 may be formed as a wall portion protruding toward the center from the inner wall of the injection port 1214. As a specific example, the supporter 1215 may be formed in a ring shape surrounding the inner wall of the injection port 1214. The supporter 1215 may reduce a diameter of the injection hole 1202 to support an inner surface of the sealing cap 130 inserted into the injection port 1214.

When the sealing cap 130 is inserted into the injection port 1214, the insertion portion 132 may cover the injection hole 1202, and the joint portion 131 may come into contact with the supporter 1215 to form a first joint surface 13101 and a second joint surface 13102. The first joint surface 13101 may be jointed to an outer surface 12151 of the supporter, and the second joint surface 13102 may be joined and fixed to an inner surface 12152 of the supporter. For example, the sealing cap 130 may be welded to the supporter 1215 through ultrasonic welding.

The potting material P may be stored in the internal space S1 of the case 100 to cover the circuit board 600. The potting material P may fill the internal space S1 of the case through the injection hole 1202 and may be provided to fill surroundings of the circuit board 600. The potting material P may be positioned to fill at least a space between the circuit board 600 and the heat dissipation structure 200.

The potting material P may include a material with high thermal conductivity and may transfer heat between the circuit board 600 and the heat dissipation structure 200. The potting material P may dissipate heat by transferring heat generated from the circuit board 600 to surroundings.

Meanwhile, the potting material P may wrap the circuit board 600 to prevent damage caused by external environmental factors. For example, the potting material P may include heat-resistant, chemical-resistant, and moistureproof materials to prevent damage to the circuit board 600 due to heat or chemicals, corrosion thereof due to moisture, or the like. In addition, the potting material P may include an insulating material to insulate a surface of the circuit board 600 and prevent electrical interference.

According to an embodiment, the potting material P may be provided as a flowable material. The potting material P may flow along the surface of the circuit board 600 and may dissipate heat generated from the circuit board 600 to a periphery.

As another example, the potting material P may be provided as a conditionally curable material and may protect the surface of the circuit board 600 through coating. For example, the potting material P may be provided as a two-liquid type silicone and may be cured when silicone is mixed with a curing agent.

Referring to FIG. 5, the first case 110 and the second case 120 may be assembled to embed the circuit board 600. Before the potting material P is injected, the internal space S1 around the circuit board 600 may be empty.

In an embodiment, the second case 120 may have a plurality of injection ports 1214. The second case 120 may have a first injection port 1214a into which the potting material P is injected, and a second injection port 1214b spaced apart from the first injection port 1214a.

The potting material P may fill the internal space S1 through the first injection port 1214a, and air present in the internal space S1 may be discharged through the second injection port 1214b. As a result, pressure may not be increased in the internal space S1, and the potting material P may be prevented from flowing back through the first injection port 1214a.

FIG. 6 is a view for describing a flow path of air in the case 100 of FIG. 2.

Referring to FIG. 6, the second case 120 may include a concave portion that is concavely recessed to allow air to flow, and the heat dissipation structure 200 may be disposed on the concave portion.

The second case 120 may include a first concave portion 1211 and a second concave portion 1212 which are recessed from an outermost surface 1210.

The first concave portion 1211 and the second concave portion 1212 may be formed by being recessed to certain depths from the outermost surface 1210. In an embodiment, the first concave portion 1211 and the second concave portion 1212 may be recessed to different depths to form a step difference.

A mount portion 1213 may be formed in any one area of the first concave portion 1211 or the second concave portion 1212. The heat dissipation structure 200 may be disposed on the mount portion 1213. Therefore, the second case 120 may form a path through which external air flows into the heat dissipation structure 200 by the first concave portion 1211 and the second concave portion 1212.

In an embodiment, the mount portion 1213 may protrude further than a bottom surface of the first concave portion 1211 or the second concave portion 1212. Since the mount portion 1213 is positioned adjacent to a path of the first concave portion 1211 and the second concave portion 1212, external air may not be blocked while passing through the first concave portion 1211 and the second concave portion 1212, thereby increasing the fluidity of air. In addition, since the mount portion 1213 protrudes from the first concave portion 1211 and the second concave portion 1212, a size of the internal space of the case 100 may be expanded to secure a space for storing the potting material.

Referring again to FIG. 1, when the microinverter 10 is installed on an external structure, the second case 120 may be installed in a direction facing the external structure. In this case, the second case 120 may have at least one gate groove, through which external air flows into the first concave portion 1211 and the second concave portion 1212, due to a shape of the first concave portion 1211 and the second concave portion 1212.

Hereinafter, in order to describe a flow of air when a plurality of gate grooves are formed in the second case 120, the lower part of the drawing is defined as a front direction of the second case 120, and the upper part of the drawing is defined as a rear direction of the second case 120.

According to an embodiment, the second case 120 may have a third gate groove G3 in the front direction, and a first gate groove G1 and a second gate groove G2 in the rear direction.

The first gate groove G1 may be positioned adjacent to the first injection port 1214a and may be connected to the first concave portion 1211. External air may flow into the first concave portion 1211 through the first gate groove G1 and may move toward the heat dissipation structure 200 along the first concave portion 1211.

The second gate groove G2 may be positioned adjacent to the first injection port 1214a and may be connected to the second concave portion 1212. External air may flow into the second concave portion 1212 through the second gate groove G2 and may move toward the heat dissipation structure 200 along the second concave portion 1212.

The third gate groove G3 may be provided as a separation space between a coupling portion of the first connector 400 and a coupling portion of the second connector 500. The third gate groove G3 may be connected to the first concave portion 1211 and may be disposed to face the heat dissipation structure 200. External air may flow into the first concave portion 1211 through the third gate groove G3 and may move toward the mount portion 1213 to come into contact with the heat dissipation structure 200.

Accordingly, the first gate groove G1, the second gate groove G2, and the third gate groove G3 may form air flow paths that communicate with each other through the first concave portion 1211 and the second concave portion 1212. The air flow path may guide external air to move toward the heat dissipation structure 200. The heat dissipation structure 200 may be positioned within a path through which the external air flows and may quickly dissipate heat received from the internal space S1 of the case 100 to the outside.

Since the third gate groove G3 faces the first gate groove G1 or the second gate groove G2 in the anteroposterior direction to be connected to the first concave portion 1211 and the second concave portion 1212, a ventilation path may be formed therebetween.

For example, when external air flows into the third gate groove G3, the external air may move along the first concave portion 1211 and the second concave portion 1212 so that heat transfer with the heat dissipation structure 200 may be performed. Air receiving heat may be discharged to the first gate groove G1 or the second gate groove G2.

Likewise, when external air flows into the first gate groove G1 or the second gate groove G2, the external air may move along the first concave portion 1211 and the second concave portion 1212 so that heat transfer with the heat dissipation structure 200 may be performed. Air receiving heat may be discharged to the third gate groove G3.

FIG. 7 is a schematic view illustrating the heat dissipation structure 200 of FIG. 2.

Referring to FIGS. 3 and 7, the heat dissipation structure 200 may be positioned to pass through the second case 120. The heat dissipation structure 200 may include a base plate 210, a first heat dissipation fin 220, a second heat dissipation fin 230, and a fastening protrusion 240.

The base plate 210 may be provided in a plate shape and may be fitted to pass through the fixing hole 1201. The first heat dissipation fin 220 may be formed on one surface of the base plate 210, and the second heat dissipation fin 230 may be formed on the other surface thereof.

The first heat dissipation fin 220 may be provided as a protrusion protruding from one surface of the base plate 210 by a certain height, and the second heat dissipation fin 230 may be provided as a protrusion protruding from the other surface of the base plate 210 by a certain height.

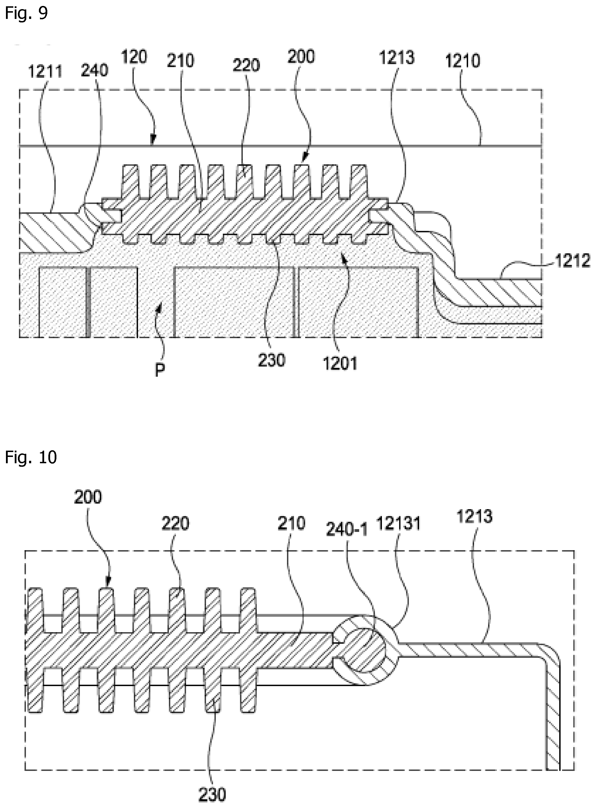

The fastening protrusion 240 may be provided as a protrusion formed on a peripheral surface of the base plate 210. As shown in FIG. 9, the fastening protrusion 240 may be provided to be fastened to and in contact with an inner surface of the fixing hole 1201 to be described below.

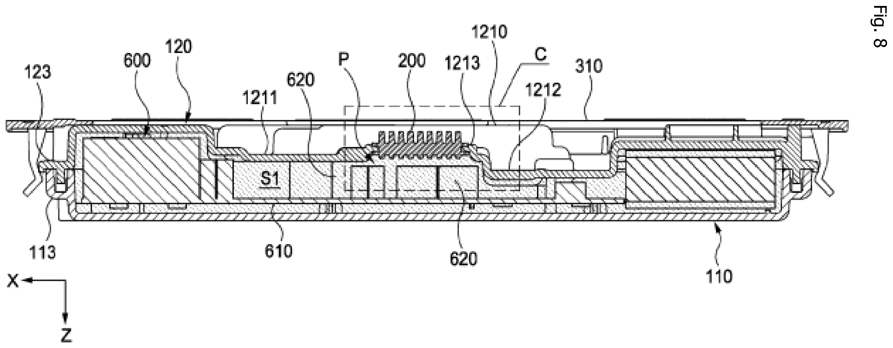

FIG. 8 is a cross-sectional view taken along line A-A' of FIG. 2. FIG. 9 is an enlarged view illustrating part C in FIG. 8.

Referring to FIGS. 2, 6, 8, and 9, the heat dissipation structure 200 may be positioned to pass through the second case 120. The base plate 210 may be inserted into the fixing hole 1201 and fastened through the fastening protrusion 240 to fix the heat dissipation structure 200.

The first case 110 and the second case 120 may seal the internal space S1 as the joint groove 112 and the base protrusion 123 are coupled to each other. The potting material P may be stored in the internal space S1. The potting material P may transfer heat generated from the circuit board 600 to the heat dissipation structure 200 and dissipate the heat to the outside or may transfer the heat to a periphery of the circuit board 600 to disperse the heat.

One surface of the heat dissipation structure 200 may be exposed to the outside of the case 100, and the other surface thereof may be in contact with the potting material P. The heat dissipation structure 200 may dissipate heat generated in the internal space S1 to the outside of the inverter 10.

Accordingly, in the microinverter 10, heat generated in the internal space S1 may be dissipated through the potting material P and the heat dissipation structure 200, a decrease in conversion efficiency and damage to components due to overheating may be prevented.

The circuit board 600 may be disposed such that the substrate unit 610 having a flat plate shape faces the first case 110, and the circuit unit 620 to which the circuit components or the like are attached faces the second case 120.

The second case 120 may correspond to a shape of the circuit unit 620 and may include the outermost surface 1210, the first concave portion 1211, the second concave portion 1212, and the mount portion 1213.

Hereinafter, an interval between the first case 110 and the second case 120 is defined as an "internal height," and a step difference between the outermost surface 1210, the first concave portion 1211, the second concave portion 1212, and the mount portion 1213 is described. That is, an internal height of the outermost surface 1210 is the maximum, and an internal height of the second concave portion 1212 is the minimum.

As described above with reference to FIG. 6, the first concave portion 1211 and the second concave portion 1212 may be recessed to certain depths from the outermost surface 1210 to form a path through which air flows to an outer surface of the second case 120. At the same time, the first concave portion 1211 and the second concave portion 1212 may be positioned adjacent to the circuit unit 620 facing inner surfaces thereof so that the circuit board 600 may be fixed, and the microinverter 10 may be manufactured more compactly.

According to an embodiment, the mount portion 1213 may be provided at an internal height at which the heat dissipation structure 200 and the circuit board 600 are not in direct contact with each other. Thus, an internal height of the mount portion 1213 may be provided to be greater than each of internal heights of the first concave portion 1211 and the second concave portion 1212. An inner surface of the heat dissipation structure 200 may be sufficiently spaced apart from the circuit unit 620 so that the second heat dissipation fin 230 may be in contact with the potting material P to cause heat transfer.

Meanwhile, when the bracket body 310 of the support bracket 300 is attached to an external structure to install the microinverter 10, as an installation surface becomes closer to the heat dissipation structure 200, the microinverter 10 may not be affected by a change in temperature of the installation surface. When the temperature of the installation surface increases, since a temperature of an outer surface of the heat dissipation structure 200 of the microinverter 10 increases, the performance of dissipating heat generated in the internal space S1 to the outside may degrade.

According to an embodiment, the mount portion 1213 may be provided at an internal height at which the heat dissipation structure 200 and the installation surface are not in direct contact with each other. Thus, the internal height of the mount portion 1213 may be provided to be less than the internal height of the outermost surface 1210. The outer surface of the heat dissipation structure 200 may be sufficiently spaced apart from the installation surface so that the first heat dissipation fin 220 may come into contact with air flowing into the first concave portion 1211 and the second concave portion 1212 to flow, thereby causing heat transfer.

FIG. 10 is a view illustrating another embodiment of the heat dissipation structure shown in FIG. 9.

A heat dissipation structure 200 of FIG. 10 may different from that of FIG. 9 in that a fastening protrusion 240-1 has a different shape. Since a first heat dissipation fin 220 and a second heat dissipation fin 230 are the same as those described above, the fastening protrusion 240-1 will be mainly described.

In the heat dissipation structure 200, the fastening protrusion 240-1 may protrude from a peripheral surface of a base plate 210 and may be provided in a ring shape. In this case, a fastening groove 12131 may be formed in a surface of a mount portion 1213 facing the fastening protrusion 240-1. The fastening protrusion 240-1 may be fitted into the fastening groove 12131 through a physical method or may be jointed to the fastening groove 12131 through a chemical method so that the heat dissipation structure 200 may be stably mounted on the mount portion 1213.

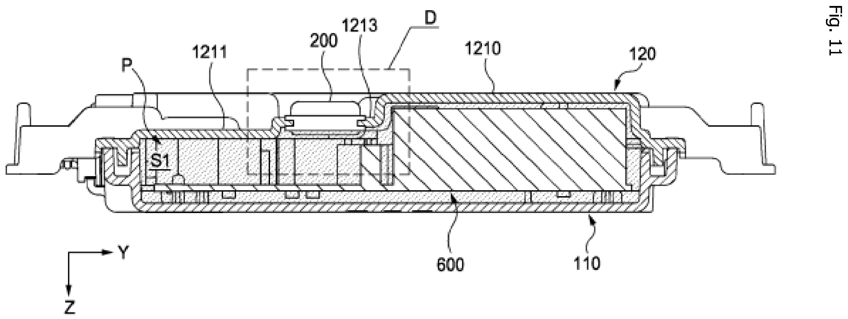

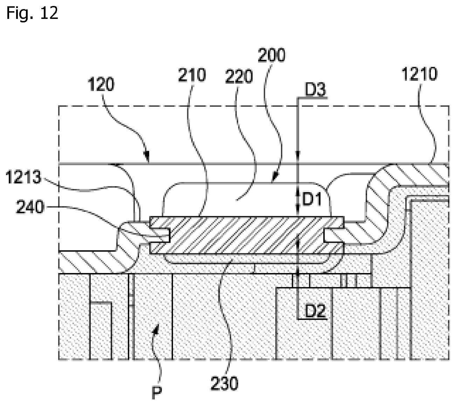

FIG. 11 is a cross-sectional view taken along line B-B' of FIG. 2. FIG. 12 is an enlarged view illustrating part D in FIG. 8.

Referring to FIGS. 7, 9, 11, and 12, in the heat dissipation structure 200, a surface area exposed to the outside may be greater than a surface area in contact with the potting material P.

In the heat dissipation structure 200, heat transfer may be accelerated through the outer surface exposed to the outside as compared to the inner surface in contact with the potting material P. In the heat dissipation structure 200, a temperature of the outer surface may be reduced relatively faster than a temperature of the inner surface. Therefore, heat generated in the internal space S1 may be effectively dissipated to the outside through the heat dissipation structure 200.

According to an embodiment, the first heat dissipation fin 220 may be formed to protrude from one surface of the base plate 210 by a first height D1. One or more second heat dissipation fins 220 may be provided. The second heat dissipation fin 230 may be formed to protrude from the other surface of the base plate 210 by a second height D2. One or more second heat dissipations fin 230 may be provided.

For a specific example, the first height D1 of the first heat dissipation fin 220 may be greater than the second height D2 of the second heat dissipation fin 230. Accordingly, a surface area of a surface on which the first heat dissipation fin 220 is formed may be greater than a surface area of a surface on which the second heat dissipation fin 230 is formed.

As another example, the number of first heat dissipation fins 220 may be greater than the number of second heat dissipation fins 230. Accordingly, the surface area of the surface on which the first heat dissipation fin 220 is formed may be greater than the surface area of the surface on which the second heat dissipation fin 230 is formed.

According to another embodiment, the first heat dissipation fin 220 and the second heat dissipation fin 230 may include different materials to have different thermal conductivities. The thermal conductivity of the first heat dissipation fin 220 may be higher than the thermal conductivity of the second heat dissipation fin 230. Thus, in the heat dissipation structure 200, heat transfer may be accelerated through the outer surface exposed to the outside as compared to the inner surface in contact with the potting material P. In the heat dissipation structure 200, a temperature of the outer surface may be reduced relatively faster than a temperature of the inner surface. Therefore, heat generated in the internal space S1 may be effectively dissipated to the outside through the heat dissipation structure 200.

The first heat dissipation fin 220 of the heat dissipation structure 200 may form a wide contact area with air, thereby increasing heat exchange efficiency. The second heat dissipation fin 230 of the heat dissipation structure 200 may maintain an effective contact area with the potting material P stored in the internal space of the case 100 and simultaneously may not disturb the fluidity of the potting material P.

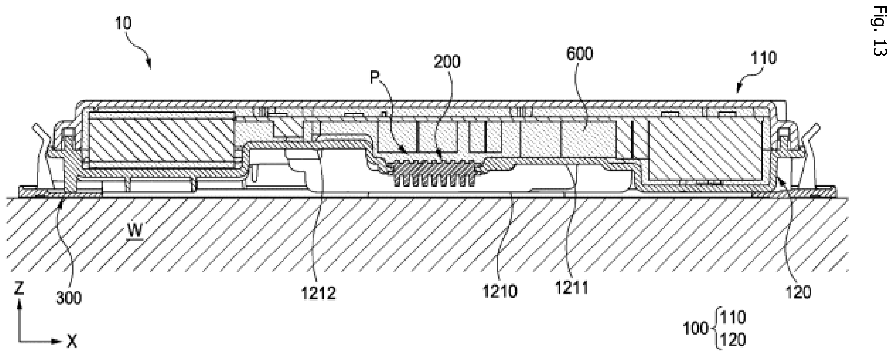

FIG. 13 is a cross-sectional view of the microinverter 10, which is installed on an external structure W, viewed from the side.

Referring to FIGS. 6 and 11 to 13, the microinverter 10 may be installed on the external structure W.

As described above, the microinverter 10 may have an exterior formed in a direction in which the first case 110 is exposed to the outside and may have an exterior formed in a direction in which the second case 120 faces the installed external structure W. The microinverter 10 may be installed by fixing the support bracket 300 to the external structure W.

The outermost surface 1210 of the second case 120 may be disposed adjacent to the external structure W on which the case 100 is installed.

The first concave portion 1211 and the second concave portion 1212 may be spaced apart from an installation surface of the external structure W so that external air flowing in through the first gate groove G1, the second gate groove G2, and the third gate groove G3 of FIG. 6 may flow therebetween.

The heat dissipation structure 200 may dissipate heat received from the circuit board 600 to the external air, and the microinverter 10 may be effectively cooled.

According to an embodiment, a certain interval may be set between the heat dissipation structure 200 and the installation surface. The heat dissipation structure 200 may be installed on the mount portion 1213 and may be further spaced apart from the installation surface. An interval between the first heat dissipation fin 220 of the heat dissipation structure 200 and the outermost surface 1210 may be formed by a third height D3. Accordingly, an interval of at least the third height D3 may be set between the heat dissipation structure 200 and the installation surface.

The present disclosure has been described with reference to embodiments shown in the accompanying drawings, but this is merely illustrative, and those skilled in the art will understand that various modifications and other equivalent embodiments are possible therefrom. Therefore, the true scope of protection of the present disclosure should be determined only by the appended claims.

## Claims

1. A microinverter comprising:
a case having an internal space in which a circuit board is disposed;
a potting material stored in the internal space of the case and configured to cover the circuit board; and
a heat dissipation structure which is disposed to pass through the case and has one side exposed to the outside of the case and another side in contact with the potting material.

2. The microinverter of claim 1, wherein
the heat dissipation structure comprises:
first heat dissipation fins protruding from the one surface by a first height; and
second heat dissipation fins protruding from the other surface by a second height.

3. The microinverter of claim 2, wherein, in the heat dissipation structure, the first height is different from the second height.

4. The microinverter of claim 2, wherein, in the heat dissipation structure, the number of the first heat dissipation fins is different from the number of the second heat dissipation fins.

5. The microinverter of claim 1, wherein, in the heat dissipation structure, a surface area exposed to the outside is greater than a surface area in contact with the potting material.

6. The microinverter of claim 1, further comprising a support bracket mounted on the case to face the heat dissipation structure and configured to support the case to an external structure.

7. The microinverter of claim 6, wherein the support bracket comprises:
a bracket body mounted on an installation surface of the external structure; and
a snap which extends from the bracket body, is connected to the case, and is configured to separate the case from the installation surface.

8. The microinverter of claim 7, wherein the heat dissipation structure is disposed on the case to face the installation surface so that a certain interval is set between the heat dissipation structure and the installation surface.

9. The microinverter of claim 1, wherein the potting material transfers heat generated from the circuit board to the heat dissipation structure.

10. The microinverter of claim 1, wherein the potting material is provided as a flowable material and flows along a surface of the circuit board to dissipate heat generated from the circuit board to surroundings.

11. A microinverter comprising:
a case which comprises a first case facing outward and a second case facing an external structure, wherein a circuit board is disposed in an internal space of the first case and the second case; a potting material stored in the internal space and configured to cover the circuit board; and
a heat dissipation structure which is disposed to pass through the second case and has one side exposed to the outside of the second case and another side in contact with the potting material, wherein the second case comprises a concave portion that is concavely recessed to allow external air to flow, and
the heat dissipation structure is disposed on the concave portion.

12. The microinverter of claim 11, wherein the concave portion is recessed to a preset depth from an outermost surface of the second case adjacent to an installation surface of the external structure on which the case is installed, and
the heat dissipation structure has a certain interval from the installation surface.

13. The microinverter of claim 11, wherein the second case has at least one gate groove which is connected to the concave portion and through which the external air flows into the concave portion.

14. The microinverter of claim 11, wherein the second case has a third gate groove which faces the heat dissipation structure and through which the external air flows into the concave portion.

15. The microinverter of claim 11, further comprising a support bracket mounted on the case to face the heat dissipation structure and configured to support the case to the external structure.

16. The microinverter of claim 11, wherein
the heat dissipation structure comprises:
a base plate mounted on the second case;
a first heat dissipation fin protruding from one surface of the base plate by a first height; and
a second heat dissipation fin protruding from another surface of
the base plate by a second height.

17. The microinverter of claim 16, wherein, in the heat dissipation structure, the first height is different from the second height.

18. The microinverter of claim 16, wherein a thickness of the base plate is less than the first height and is greater than the second height.

19. The microinverter of claim 11, wherein the second case comprises:
a first injection port through which the potting material is injected; and
a second injection port spaced apart from the first injection port.

20. The microinverter of claim 19, wherein the second case comprises:
a first gate groove adjacent to the first injection port and connected to the concave portion;
a second gate groove adjacent to the second injection port and connected to the concave portion; and
a third gate groove disposed at a side opposite to the first gate groove or the second gate groove and connected to the concave portion.
